# EUROPÄISCHE PATENTSCHRIFT

(11) **EP 4 138 146 B1**
(45) Veröffentlichungstag und Bekanntmachung des Hinweises auf die Patenterteilung: **23.09.2026**
(21) Anmeldenummer: 22199689.5
(22) Anmeldetag: 06.04.2020
(51) Int. Cl.: H10D 8/00, H10D 62/40, H10D 62/82, H10D 62/824

(54) **STAPELFÖRMIGE HOCHSPERRENDE III-V-HALBLEITERLEISTUNGSDIODE**
STACKED HIGH BLOCKING III-V SEMICONDUCTOR POWER DIODE
DIODE EMPILÉE DE PUISSANCE À SEMI-CONDUCTEUR III-V À BLOCAGE ÉLEVÉ

(30) Priorität: 30.04.2019 DE 102019003069
(43) Veröffentlichungstag der Anmeldung: 22.02.2023
(62) Dokumentnummer(n) der früheren Anmeldung(en) nach Art. 76 EPÜ: 20000143.6 / 3 734 667
(73) Patentinhaber: AZUR SPACE Solar Power GmbH, 74072 Heilbronn (DE)
(72) Erfinder: FUHRMANN, Daniel, 74081 Heilbronn (DE); KELLER, Gregor, 74080 Heilbronn (DE); WÄCHTER, Clemens, 74348 Lauffen am Neckar (DE)
(74) Vertreter: Koch Müller Patentanwaltsgesellschaft mbH

(56) Entgegenhaltungen:
- DE-A1- 102016 013 540
- US-B2- 9 305 772
- RYBALCHENKO D V ET AL: "Metamorphic InGaAs photo-converters on GaAs substrates", JOURNAL OF PHYSICS: CONFERENCE SERIES, INSTITUTE OF PHYSICS PUBLISHING, BRISTOL, GB, vol. 690, no. 1, 26 February 2016 (2016-02-26), pages 12032, XP020296752, ISSN: 1742-6596, [retrieved on 20160226], DOI: 10.1088/1742-6596/690/1/012032
- TANZID M ET AL: "Analysis of electrical and optical characteristics of InGaSb PIN photodiodes", IET OPTOELECTRONICS, THE INSTITUTION OF ENGINEERING AND TECHNOLOGY, MICHAEL FARADAY HOUSE, SIX HILLS WAY, STEVENAGE, HERTS. SG1 2AY, UK, vol. 6, no. 5, 1 October 2012 (2012-10-01), pages 242 - 249, XP006042943, ISSN: 1751-8768, DOI: 10.1049/IET-OPT.2011.0101

## Beschreibung

Die Erfindung betrifft eine stapelförmige hochsperrende III-V-Leistungshalbleiterdiode.

Aus "GaAs Power Devices" von German Ashkinazi, ISBN 965-7094-19-4, Seite 8 und 9 ist eine hochspannungsfeste PIN-Halbleiterdiode aus GaAs bekannt. Stapelförmige hochsperrende III-V-Halbleiterleistungsdioden und entsprechende Herstellungsverfahren sind aus den Druckschriften DE 10 2016 013 541 A1, DE 10 2016 015 056 A1, DE 10 2017 002 935 A1 und DE 10 2017 002 936 A1 bekannt.

Die DE 10 2016 013 540 A1 offenbart eine stapelförmige hochsperrende III-V-Halbleiterleistungsdiode, aufweisend eine erste metallische Anschlusskontaktschicht, einen hochdotierten Halbleiterkontaktbereich eines ersten Leitfähigkeitstyps, eine dotierte Zwischenschicht des ersten Leitfähigkeitstyps, eine Driftschicht eines zweiten Leitfähigkeitstyps, eine Halbleiterkontaktschicht des zweiten Leitfähigkeitstyps, wobei die Dotierstoffkonzentration der Zwischenschicht größer als die Dotierstoffkonzentration der Driftschicht ist, und eine zweite metallische Anschlusskontaktschicht, die stoffschlüssig mit der Halbleiterkontaktschicht verbunden ist, wobei die offenbarte Diode aus einer GaAs Verbindung besteht.

Aus der JP S55-80375 A und der US 3,995,303 A sind Photodioden mit InGaAs-Schichten bekannt. Ein Verfahren zum Bonden von InP und GaAs ist aus der CN 100 356 507 C bekannt.

Aus RYBALCHENKO D V ET AL: "Metamorphic InGaAs photo-converters on GaAs substrates", JOURNAL OF PHYSICS: CONFERENCE SERIES, INSTITUTE OF PHYSICS PUBLISHING, BRISTOL, GB, Bd. 690, Nr. 1, 26. Februar 2016 (2016-02-26), Seite 12032, XP020296752, ISSN: 1742-6596, der US 9 305 772 B2, aus TANZID M ET AL: "Analysis of electrical and optical characteristics of InGaSb PIN photodiodes", IET OPTOELECTRONICS, THE INSTITUTION OF EN-GINEERING AND TECHNOLOGY, MICHAEL FARADAY HOUSE, SIX HILLS WAY, STEVENAGE, HERTS. SG1 2AY, UK, Bd. 6, Nr. 5, 1. Oktober 2012 (2012-10-01), Seiten 242-249, XP006042943, ISSN: 1751-8768 sind weitere III-V Bauelemente bekannt.

Gattungsgemäße Dioden weisen Durchbruchspannungen oberhalb von 200V auf und sollten neben einer niedrigen Vorwärtsspannung einen geringen Serienwiderstand aufweisen, um die Verlustleistung zu reduzieren. Des Weiteren sollten die Dioden in Sperrrichtung möglichst geringe Leckströme von unterhalb 1 µA aufweisen.

Vor diesem Hintergrund besteht die Aufgabe der Erfindung darin, eine Vorrichtung anzugeben, die den Stand der Technik weiterbildet.

Die Aufgabe wird durch eine stapelförmige hochsperrende III-V-Halbleiterleistungsdiode mit den Merkmalen des Patentanspruchs 1 oder mit den Merkmalen des Patentanspruchs 2 gelöst. Vorteilhafte Ausgestaltungen der Erfindung sind jeweils Gegenstand von Unteransprüchen.

Gemäß dem ersten Gegenstand der Erfindung wird eine stapelförmige hochsperrende III-V-Halbleiterleistungsdiode bereitgestellt, aufweisend eine zumindest gebietsweise ausgebildete erste metallische Anschlusskontaktschicht und einen hochdotierten Halbleiterkontaktbereich eines ersten Leitfähigkeitstyps mit einer Dotierstoffkonzentration größer als 1•10¹⁸ N/cm³ und mit einer ersten Gitterkonstante.

Des Weiteren ist eine Driftschicht eines zweiten Leitfähigkeitstyps mit der ersten Gitterkonstante und mit einer Schichtdicke größer als 10 µm vorgesehen.

Außerdem ist eine hochdotierte metamorphe Pufferschichtfolge von dem zweiten Leitfähigkeitstyp mit einer Schichtdicke oberhalb 0,2 µm und kleiner als 20 µm ausgebildet.

Die metamorphe Pufferschichtfolge weist eine Oberseite mit der ersten Gitterkonstante und eine Unterseite mit einer zweiten Gitterkonstante auf, wobei die erste Gitterkonstante größer als die zweite Gitterkonstante ist.

Die Oberseite der metamorphen Pufferschichtfolge ist in Richtung der Driftschicht angeordnet. Die Unterseite in Richtung eines zweiten metallischen Anschlusskontaktes.

Unterhalb der Unterseite der metamorphen Pufferschichtfolge ist die zweite metallische Anschlusskontaktschicht angeordnet.

Es sei angemerkt, dass die vorgenannten Bereiche und Schichten in der genannten Reihenfolge angeordnet sind.

Die zweite metallische Anschlusskontaktschicht ist stoffschlüssig mit einer Halbleiterkontaktschicht verbunden.

Der hochdotierte Halbleiterkontaktbereich und die Driftschicht umfassen jeweils eine III-V Verbindung oder bestehen aus Elementen einer III-V Verbindung.

Gemäß dem zweiten Gegenstand der Erfindung wird eine stapelförmige hochsperrende III-V-Halbleiterleistungsdiode bereitgestellt, aufweisend eine zumindest gebietsweise ausgebildete erste metallische Anschlusskontaktschicht und einen hochdotierten Halbleiterkontaktbereich eines zweiten Leitfähigkeitstyps mit einer Dotierstoffkonzentration größer als 1•10¹⁸ N/cm³ und mit einer ersten Gitterkonstante.

Des Weiteren ist eine Driftschicht des zweiten Leitfähigkeitstyps mit der ersten Gitterkonstante und mit einer Schichtdicke größer als 10 µm vorgesehen. Außerdem ist eine hochdotierte metamorphe Pufferschichtfolge von dem ersten Leitfähigkeitstyp mit einer Schichtdicke oberhalb 0,2 µm und kleiner als 20 µm ausgebildet.

Die metamorphe Pufferschichtfolge weist eine Oberseite mit der ersten Gitterkonstante und eine Unterseite mit einer zweiten Gitterkonstante auf, wobei die erste Gitterkonstante größer ist als die zweite Gitterkonstante.

Die Oberseite der metamorphen Pufferschichtfolge ist in Richtung der Driftschicht angeordnet, die Unterseite der metamorphen Pufferschichtfolge ist in Richtung eines zweiten metallischen Anschlusskontaktes angeordnet.

Unterhalb der Unterseite der metamorphen Pufferschichtfolge ist der zweite metallische Anschlusskontaktschicht angeordnet.

Es sei angemerkt, dass die vorgenannten Bereiche und Schichten in der genannten Reihenfolge angeordnet sind.

Die zweite metallische Anschlusskontaktschicht ist stoffschlüssig mit einer Halbleiterkontaktschicht verbunden.

Der hochdotierte Halbleiterkontaktbereich und die Driftschicht umfassen eine III-V Verbindung oder bestehen aus Elementen einer III-V Verbindung.

Es sei angemerkt, dass mit dem Ausdruck "besteht aus Elementen einer III-V Verbindung" eine Verbindung aus den genannten Stoffen ohne weitere III-V Elemente verstanden wird, jedoch Dotierstoffen wie beispielsweise Zink oder Silizium oder Zinn oder Kohlenstoff umfasst sind. Folglich bedeutet beispielsweise "besteht aus GaAs", das als III-V Elementen ausschließlich Gallium und Arsen jedoch nicht In oder Al oder P usw. eingebaut sind.

Mit dem Ausdruck "eine Verbindung umfassend" bedeutet entsprechend beispielsweise für GaAs, dass neben Gallium und Arsen weitere III-V Elemente wie beispielsweise Phosphor, Aluminium oder Indium enthalten sein können, zusätzlich zu eventuellen Dotierstoffen.

Vorzugsweise sind die III-V Halbleiterschichten jeweils zueinander zumindest teilweise planar oder teilweise wannenförmig ausgebildet, wobei die laterale Ausbildung der jeweiligen III-V Halbleiterschichten für die planare Anordnung vorzugsweise gleich groß ist.

Auch sei angemerkt, dass der Ausdruck "Halbleiterschicht" mit dem Ausdruck "Halbleiterbereich" vorzugsweise synonym verwendet wird. Jedoch wird mit dem Ausdruck "Halbleiterbereich" eine im Allgemeinen wannenförmige Ausbildung des Zwischenbereichs und mit dem Ausdruck "Halbleiterschicht" im Allgemeinen eine Schicht zumindest mit einer planen Unterseite und / oder mit einer planen Oberseite bezeichnet.

Auch sei angemerkt, dass die metallischen Anschlusskontaktschichten jeweils elektrisch sehr gut leitfähig sind und umfassen oder bestehen vorzugsweise aus einen oder mehreren Metallschichten, wobei die Metallschichten bevorzugt auch Verbindungen wie beispielsweise Ge und / oder Au und / oder Pd umfassen.

Die Anschlusskontaktschichten stellen einen elektrisch niederohmigen Kontakt zu den unmittelbar angrenzenden hochdotierten Halbleiterkontaktschichten her. Es versteht sich, dass die jeweiligen Halbleiterkontaktschichten an einer Oberseite oder an einer Unterseite der III-V Halbleiterleistungsdioden unmittelbar angrenzend zu den metallischen Anschlusskontaktschichten ausgebildet sind.

Des Weiteren versteht es sich, dass die Anschlusskontaktschichten vorzugsweise mittels Bonddrähten mit Kontaktfingern, den sogenannten Pins, verschaltet sind, indem die Halbleiterleistungsdioden auf einem Träger beispielsweise in Form eines Leadframes angeordnet sind.

Auch sei angemerkt, dass die Durchbruchsspannung der hochsperrenden III-V Halbleiterleistungsdioden oberhalb 200 V liegt. Insbesondere liegt die Durchbruchsspannung der hochsperrenden III-V Halbleiterleistungsdioden in einem Bereich zwischen 300V und 2000 V oder in einem Bereich zwischen 600 V und 1200 V oder in einen Bereich zwischen 1000 V und 1400 V oder in einen Bereich zwischen 1200 V und 2000 V.

Ein Vorteil der unterschiedlichen Gitterkonstanten ist es, dass sich oberhalb des metamorphen Puffers III-V- Verbindungen oder III-V - Materialien mit kleinerer Bandlücke verwenden lassen, als die III-V Schichten oder die III-V Substrate oder die Gruppe IV Substrate unterhalb der metamorphen Pufferschichtfolge.

Anders ausgedrückt, mittels der metamorphen Pufferschichtfolge lassen sich die oberhalb der metamorphen Pufferschichtfolge liegenden aktiven Schichten der hochsperrenden Leistungsdiode hinsichtlich der elektrischen Eigenschaften von den elektrischen Eigenschaften der unterhalbliegenden Schichten zumindest teilweise entkoppeln.

Insbesondere lassen sich für die aktiven Schichten III-V Verbindungen, mit einer Beweglichkeit die oberhalb von GaAs liegt und mit einer im Vergleich zu GaAs geringeren Vorwärtsspannung, aufwachsen. Vorzugsweise lässt sich hierzu eine Verbindung von InGaAs mit einer Gitterkostante im Bereich von der Gitterkonstante von InP oder mit einer Gitterkonstante genau wie die Gitterkonstante von InP verwenden.

Mit einer geringeren Vorwärtsspannung lassen sich im Durchlassfall die Verluste durch die III-V - Halbleiterleistungsdiode stark reduzieren. Mit einer höheren Beweglichkeit verbessern sich die transienten elektrischen Eigenschaften, wie beispielsweise die Schaltfrequenz und der Serienwiderstand der III-V Halbleiterleistungsdiode. Anderseits lässt sich als Wachstumssubstrat ein günstiges III-V Material, wie beispielsweise GaAs, oder Ge verwenden.

Ein anderer Vorteil ist, dass bei den III-V Halbleiterleistungsdioden im Vergleich zu Silizium oder teilweise auch SiC insbesondere die Elektronen eine kleinere effektive Masse bzw. eine höhere Beweglichkeit aufweisen.

Auch lassen sich mit den III-V Halbleiterleistungsdioden im Vergleich zu Si höhere Temperaturen an den p/n-Übergängen erreichen, ohne dass die III-V Halbleiterdioden zerstört werden. So lassen sich III-V Halbleiterdioden bis zu Temperaturen von 300°C, d.h. auch in heißen Umgebungen, einsetzen.

Ein weiterer Vorteil im Vergleich zu SiC ist, dass sich III-V Halbleiterleistungsdioden wesentlich kostengünstiger als Halbleiterstrukturen aus SiC mit vergleichbaren elektrischen Eigenschaften herstellen lassen.

Erfindungsgemäß ist die hochdotierte metamorphe Pufferschichtfolge von dem zweiten Leitfähigkeitstyp oder von dem ersten Leitfähigkeitstyp und weist in einer Weiterbildung eine Dotierstoffkonzentration größer als 5•10¹⁷ N/cm³ oder größer als 1•10¹⁷ N/cm³ oder größer als 3•10¹⁶ N/cm³ oder größer als 1•10¹⁶ N/cm³ auf.

In einer nicht beanspruchten Ausführungsform grenzt der Halbleiterkontaktbereich unmittelbar an die Driftschicht an.

Erfindungsgemäß ist der hochdotierte Halbleiterkontaktbereich durch eine dotierte Zwischenschicht eines ersten Leitfähigkeitstyps mit einer Dotierstoffkonzentration kleiner als 5•10¹⁵ N/cm³ und mit einer ersten Gitterkonstante und mit einer Dicke zwischen 1 µm und 30 µm von der Driftschicht beabstandet.

In einer Ausführungsform grenzt die metamorphe Pufferschichtfolge unmittelbar an die Driftschicht an. In einer Ausführungsform ist die metamorphe Pufferschichtfolge durch eine dotierte Zwischenschicht eines ersten Leitfähigkeitstyps mit einer ersten Gitterkonstante und mit einer Dicke zwischen 1 µm und 30 µm von der Driftschicht beabstandet ist. In einer Weiterbildung weist die Zwischenschicht eine Dotierstoffkonzentration kleiner als 5•10¹⁵ N/cm³ auf.

Vorzugsweise umfasst die Zwischenschicht gemäß alternativer Weiterbildungen als Dotierstoffe Zink und / oder Silizium und/oder Kohlenstoff. Die Dotierstoffkonzentration der Zwischenschicht ist bevorzugt kleiner als die Dotierstoffkonzentration des unmittelbar an die Zwischenschicht angrenzenden hochdotierten Halbleiterkontaktbereichs. Erfindungsgemäß ist die Dotierstoffkonzentration der Zwischenschicht in einem Bereich zwischen einem Faktor 2 bis zu einem Faktor von vier Größenordnungen kleiner als die Dotierstoffkonzentration des unmittelbar an die Zwischenschicht angrenzenden hochdotierten Halbleiterkontaktbereichs.

Vorzugsweise ist die Dotierstoffkonzentration der Zwischenschicht größer als die Dotierstoffkonzentration der Driftschicht. Höchst vorzugsweise ist die Dotierstoffkonzentration der Zwischenschicht mindestens um einen Faktor 2 bis zu einem Faktor 100 oder mindestens um einen Faktor 10 bis zu einem Faktor 50 größer als die Dotierstoffkonzentration der Driftschicht.

Es versteht sich, dass in allen Ausführungsformen die Zwischenschicht einen anderen Leitfähigkeitstyp als die Driftschicht aufweist, so dass sich der p/n Übergang der Halbleiterleistungsdiode jeweils zwischen der Driftschicht und der Zwischenschicht ausbildet, sofern eine Zwischenschicht ausgebildet ist.

Vorzugsweise ist die Zwischenschicht p-dotiert ausgebildet.

In einer Weiterbildung sind die erste metallische Anschlusskontaktschicht stoffschlüssig mit dem Halbleiterkontaktbereich und die zweite metallische Anschlusskontaktschicht stoffschlüssig mit der Halbleiterkontaktschicht verbunden.

In einer Ausführungsform ist unterhalb der metamorphen Pufferschichtfolge eine Substratschicht von dem ersten Leitfähigkeitstyp oder von dem zweiten Leitfähigkeitstyp vorgesehen.

Vorzugsweise weist die Substratschicht die zweite Gitterkonstante auf und umfasst Ge oder GaAs oder Si oder InP. In einer anderen Ausführungsform besteht die Substratschicht aus Ge oder GaAs oder Si oder InP.

In einer Weiterbildung ist zwischen der Driftschicht und der zweiten metallischen Anschlussschicht eine Substratschicht von dem ersten Leitfähigkeitstyp oder von dem zweiten Leitfähigkeitstyp ausgebildet ist und die Substratschicht eine Schichtfolge mit InP und GaAs umfasst oder aus der Schichtfolge InP und GaAs besteht.

In einer nicht erfindungsgemäßen Weiterbildung ist die metamorphe Pufferschichtfolge als Halbleiterkontaktschicht ausgebildet. Ein Vorteil ist, dass hierdurch die stapelförmige hochsperrende III-V-Halbleiterleistungsdiode dünner ist als mit einem unterhalb der Pufferschichtenfolge ausgebildetem Substrat. Es versteht sich, dass sich der Serienwiderstand der stapelförmigen Halbleiterleistungsdiode mit abnehmender Dicke der Schichtenfolge reduziert.

Erfindungsgemäß ist die Gesamtdicke der Pufferschichtenfolge geringer als 20 µm aber größer als 0,2 µm. Hierdurch liegt die Gesamtdicke des Stapels der III-V Halbleiterleistungsdiode in einem Bereich zwischen 15 µm bis 30 µm oder in einen Bereich zwischen 20 µm und 40 µm oder ist kleiner als 60 µm oder ist kleiner als 40 µm oder ist kleiner als 120 µm oder ist kleiner als 180 µm.

Erfindungsgemäß besteht die metamorphe Pufferschichtfolge aus InₓGa₁₋ₓAs mit 0≤x≤1, wobei an einer Unterseite x<0,02 (z.B. x=0) ist und x an der Oberseite größer ist als der Wert von x an der Unterseite. Vorzugsweise liegt der Grenzwert bei x < 1, höchst vorzugsweise bei x<0,8 oder bei x<0,6 oder bei x< 0,4.

Im Allgemeinen nimmt x zwischen den einzelnen Schichten der Pufferschichtenfolge ausgehend von der Unterseite bis hin zur Oberseite der Pufferschichtenfolge zu, wobei in einer alternativen Ausführungsform bei wenigen unmittelbar aufeinanderfolgenden Schichten der Wert von x etwas abnimmt. Zwischen der Mehrzahl der Schichten der Pufferschichtenfolge nimmt der Wert von x zwischen zwei unmittelbar aufeinanderfolgenden Schichten zu. Hierbei erfolgt die Zunahme von x entweder stufenförmig oder linear oder anderweitig.

Indem der Wert von x an der Oberseite der metamorphen Pufferschichtfolge immer größer ist als der Wert von x an der Unterseite der metamorphen Pufferschichtfolge ist die Gitterkonstante an der Oberseite größer als die Gitterkonstante an der Unterseite. Erfindungsgemäß die Bandlücke an der Oberseite kleiner als an der Unterseite der metamorphen Pufferschichtenfolge. Hierdurch erniedrigt sich die Vorwärtsspannung der Halbleiterleistungsdiode.

In einer Weiterbildung nimmt der Wert von x von der Unterseite bis hin zu der Oberseite monoton zu. In einer anderen Weiterbildung weist der Wert von x in der Nähe der Oberseite der Pufferschichtenfolge ein lokales Maximum oder ein lokales Minimum auf und nimmt in Richtung der Oberseite ab oder zu. Vorzugsweise ist der Wert von x innerhalb der jeweiligen Schicht der Pufferschichtfolge konstant.

Erfindungsgemäß ist zwischen der metamorphen Pufferschichtfolge und der zweiten metallischen Anschlusskontaktschicht eine Halbleiterkontaktschicht ausbildende erste hochdotierte Halbleiterschicht angeordnet, wobei die erste hochdotierte Halbleiterschicht die zweite Gitterkonstante aufweist.

Die erste hochdotierte Halbleiterschicht ist von dem selbem Leitfähigkeitstyp der metamorphen Pufferschichtfolge. Die erste hochdotierte Halbleiterschicht weist eine Dotierstoffkonzentration größer als 1•10¹⁸ N/cm³ und eine Schichtdicke oberhalb von 0,1 µm auf.

Alternativ weist die erste hochdotierte Halbleiterschicht eine Dotierstoffkonzentration zwischen 5•10¹⁸ N/cm³ und 5•10¹⁹ N/cm³ und eine Schichtdicke zwischen 0,5 µm und 4 µm auf.

In einer nicht erfindungsgemäßen Ausführungsform ist die erste hochdotierte Halbleiterschicht unterhalb der metamorphen Pufferschichtfolge als Teil der Substratschicht ausgebildet. In einer Ausführungsform besteht die Substratschicht aus GaAs oder aus Ge, wobei der Wert x für einen InₓGa₁₋ₓAs metamorphen Puffer an der Unterseite für eine GaAs Substratschicht gleich null ist und der Wert von x für einen InₓGa₁₋ₓAs metamorphen Puffer an der Unterseite für eine Ge Substratschicht zwischen 0 und 0,02 liegt.

In einer nicht erfindungsgemäßen Ausführungsform ist die Substratschicht als Halbleiterkontaktschicht von dem zweiten Leitfähigkeitstyp oder von dem ersten Leitfähigkeitstyp ausgebildet. Vorzugsweise liegt die Dicke der Substratschicht zwischen 10 µm und 250 µm. Alternativ liegt die Dicke der Substratschicht zwischen 50 µm und 130 µm oder zwischen 150 µm und 650 µm.

In einer Weiterbildung ist eine zweite hochdotierte Halbleiterschicht mit der ersten Gitterkonstante zwischen der metamorphen Pufferschichtfolge und der Driftschicht ausgebildet. Die zweite hochdotierte Halbleiterschicht ist von dem zweiten Leitfähigkeitstyp oder von dem ersten Leitfähigkeitstyp und weist eine Dotierstoffkonzentration größer als 1•10¹⁸ N/cm³ und eine Schichtdicke oberhalb von 0,1 µm auf.

Alternativ weist die zweite hochdotierte Halbleiterschicht eine Dotierstoffkonzentration zwischen 5•10¹⁸ N/cm³ und 5•10¹⁹ N/cm³ und eine Schichtdicke zwischen 0,5 µm und 4 µm oder zwischen 0,3 µm und 10 µm auf.

In einer Ausführungsform umfassen der Halbleiterkontaktbereich und die zwischen dem Halbleiterkontaktbereich und der Oberseite der metamorphen Pufferschichtfolge angeordneten Halbleiterschichten jeweils eine InGaAs Verbindung oder bestehen aus InGaAs.

In einer anderen Ausführungsform ist der erste Leitfähigkeitstyp p und der zweite Leitfähigkeitstyp n oder der erste Leitfähigkeitstyp n und der zweite Leitfähigkeitstyp p.

Vorzugsweise ist der Halbleiterkontaktbereich als planare Schicht oder wannenförmig ausgebildet. Insbesondere bei einer epitaktischen Ausbildung ist der hochdotierte Halbleiterkontaktbereich als planare Schicht ausgebildet, während bei einer Implantation der hochdotierte Halbleiterkontaktbereich vorzugsweise wannenförmig ausgebildet ist, indem zur Ausbildung des Halbleiterkontaktbereichs Dotierstoffe in den Bereich der Driftschicht implantiert sind.

In einer Weiterbildung besteht die erste hochdotierte Halbleiterschicht aus GaAs oder die erste Halbleiterschicht umfasst eine GaAs Verbindung. Vorzugsweise umfasst die Driftschicht und der Halbleiterkontaktbereich jeweils eine InGaAs Verbindung oder bestehen jeweils aus InGaAs.

In einer anderen Weiterbildung umfassen die zweite hochdotierte Halbleiterschicht und die Driftschicht und der Halbleiterkontaktbereich jeweils eine InGaAs Verbindung oder die zweite Halbleiterkontaktschicht und die Driftschicht und der Halbleitkontaktbereich bestehen jeweils aus InGaAs, wobei vorzugsweise die Driftschicht aus InₓGa₁₋ₓAs mit 0,1<x<0,6 besteht.

In einer Ausführungsform sind der Halbleiterkontaktbereich und die Halbleiterschichten monolithisch ausgebildet, d.h. die Schichten der Halbleiterleistungsdiode sind stapelförmig ohne Halbleiterbond aufeinander angeordnet.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: eine Querschnittsansicht auf eine erste nicht beanspruchte Ausführungsform einer Halbleiterleistungsdiode,
- Figur 2: eine Querschnittsansicht auf eine zweite nicht beanspruchte Ausführungsform einer Halbleiterleistungsdiode,
- Figur 3: eine Querschnittsansicht auf eine dritte nicht beanspruchte Ausführungsform einer Halbleiterleistungsdiode,
- Figur 4: eine Querschnittsansicht auf eine vierte nicht beanspruchte Ausführungsform einer Halbleiterleistungsdiode,
- Figur 5: eine Querschnittsansicht auf eine fünfte nicht beanspruchte Ausführungsform einer Halbleiterleistungsdiode,
- Figur 6: eine Querschnittsansicht auf eine sechste nicht beanspruchte Ausführungsform einer Halbleiterleistungsdiode,
- Figur 7: eine Querschnittsansicht auf eine siebte nicht beanspruchte Ausführungsform einer Halbleiterleistungsdiode,
- Figur 8: eine Querschnittsansicht auf eine achte nicht beanspruchte Ausführungsform einer Halbleiterleistungsdiode,
- Figur 9: eine Querschnittsansicht auf eine neunte nicht beanspruchteAusführungsform einer Halbleiterleistungsdiode,
- Figur 10: eine Querschnittsansicht auf eine erste erfindungsgemäße Ausführungsform einer Halbleiterleistungsdiode.

Bei allen Abbildungen ist aus Gründen der Übersichtlichkeit jeweils nur eine Schnittansicht bzw. eine Querschnittsansicht einer III-V- Halbleiterleistungsdiode dargestellt.

Es sei jedoch angemerkt, dass alle in der Schnittansicht abgebildeten III-V-Halbleiterleistungsdioden in einer Draufsicht entweder einen quadratischen oder einen rechteckigen oder einen rechteckigen Umfang mit abgerundeten Kanten oder einen runden Umfang aufweisen.

Anders ausgedrückt, in der Draufsicht weisen die III-V- Halbleiterleistungsdiode die gleichen Schichtfolgen wie in der jeweiligen Querschnittsansicht auf.

Auch gilt, dass die Halbleiterkontaktbereiche und die Halbleiterschichten jeweils eine III-V Verbindung umfassen oder bestehen aus den Elementen einer III-V Verbindung, wobei jeder Halbleiterbereich und jede Halbleiterschicht jeweils eine Oberseite und eine Unterseite aufweisen.

Die Oberseite zeigt hierbei jeweils in Richtung des an der Oberseite des Schichtstapels angeordneten Metallkontakts bzw. metallischen Anschlusskontakts, während die Unterseite jeweils in Richtung des an der Unterseite des Schichtstapels angeordneten Metallkontakts bzw. metallischen Anschlusskontakts zeigt.

Auch sei für alle Ausführungsformen angemerkt, dass der Ausdruck "Zwischenschicht" mit dem Ausdruck "Zwischenbereich" vorzugsweise synonym verwendet wird.

Jedoch wird mit dem Ausdruck "Zwischenbereich" oder mit dem Ausdruck "Halbleiterkontaktbereich" eine im Allgemeinen wannenförmige Ausbildung bezeichnet, demhingegen ist mit dem Ausdruck "Zwischenschicht" oder "Halbleiterkontaktschicht" im Allgemeinen jeweils eine Schicht mit zumindest einer planen Unterseite und / oder mit einer planen Oberseite bezeichnet.

Insbesondere umfassen die abgebildeten metamorphen Puffer eine Vielzahl von III-V-Halbleiterschichten oder bestehen aus einer Vielzahl von III-V-Halbleiterschichten, wobei sich die Gitterkonstante im Allgemeinen von III-V Halbleiterschicht zu III-V Halbleiterschicht ändert.

Unter einer Vielzahl wird vorliegend eine Anzahl von mindestens drei und maximal dreißig oder eine Anzahl von mindestens fünf und maximal zehn Halbleiterschichten verstanden. Des Weiteren ist der metamorphe Puffer jeweils möglichst niederohmig, d.h. hochdotiert ausgeführt.

Des Weiteren gilt für alle dargestellten Ausführungsformen, dass die III-V-Halbleiterleistungsdiode eine Oberseite und eine Unterseite aufweisen, wobei vorzugsweise mittels einer an der Unterseite ausgebildeten metallischen Anschlusskontaktschicht die III-V- Halbleiterleistungsdiode als sogenanntes "DIE" auf einer als Metallrahmen bzw. Metallträger auch "Leadframe" genanntem Unterlage angeordnet sind.

Eine möglichst große insbesondere ganzflächige Ausbildung der metallischen Anschlusskontaktschicht an der Unterseite verbessert die thermische Ankopplung an die Unterlage.

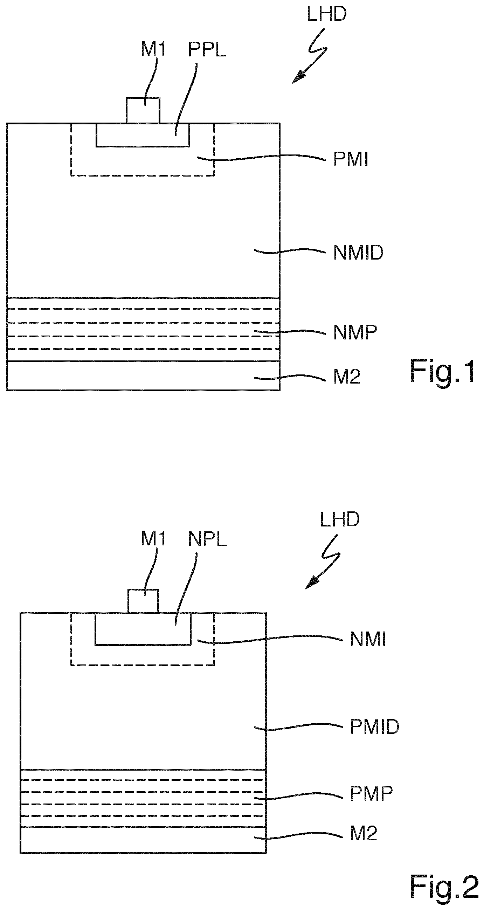

Die Abbildung der Figur 1 zeigt eine nicht beanspruchte Ausführungsform stapelförmige hochsperrende III-V-Halbleiterleistungsdiode LHD in einer p / n Struktur.

Die Halbleiterleistungsdiode LHD weist eine gebietsweise ausgebildete erste metallische Anschlusskontaktschicht M1 und einen p+ hochdotierten Halbleiterkontaktbereich PPL mit einer Dotierstoffkonzentration größer als 1•10¹⁸ N/cm³ und mit einer ersten Gitterkonstante auf.

Der Halbleiterkontaktbereich PPL ist wannenförmig ausgebildet und ist vorzugsweise mittels eines Masken- und Implantationsprozesses hergestellt. Hierbei werden Dotierstoffe in einen Bereich der n- Driftschicht oder der p-Driftschicht eingebracht, wobei vorzugsweise die Dotierstoffe mittels eines Temperaturprozesses aktiviert werden. Die erste metallische Anschlusskontaktschicht M1 und der p+ hochdotierte Halbleiterkontaktbereich PPL sind stoffschlüssig miteinander verbunden.

Zwischen dem p+ hochdotierten Halbleiterkontaktbereich PPL und einer n-Driftschicht NMID ist ein p- Zwischenbereich PMI in einer wannenförmigen Ausbildung angeordnet, so dass der p+ hochdotierte Halbleiterkontaktbereich PPL allseitig von der n- Driftschicht NMID beabstandet ist. Der p- dotierte Zwischenbereich ist gestrichelt gezeichnet, da der p- dotierte Zwischenbereich optional ist, d.h. in einer nicht dargestellten Ausführungsform ist der p- Zwischenbereich nicht ausgebildet. Es versteht sich, dass ohne den p- Zwischenbereich PMI der p+ hochdotierte Halbleiterkontaktbereich PPL stoffschlüssig mit der n- Driftschicht NMID verbunden ist.

Der p- Zwischenbereich PMI weist eine Dotierung kleiner als der p+ hochdotierte Halbleiterkontaktbereich PPL und größer als die n- Driftschicht NMID auf und ist stoffschlüssig mit dem p+ hochdotierte Halbleiterkontaktbereich PPL und der n- Driftschicht NMID verbunden. Der p- Zwischenbereich PMI weist eine Dotierstoffkonzentration kleiner als 5•10¹⁵ N/cm³ und die erste Gitterkonstante und eine Dicke zwischen 1 µm und 30 µm auf.

Die III-V Halbleiterleistungsdiode LHD weist neben der n- Driftschicht NMID mit der ersten Gitterkonstante und mit einer Schichtdicke größer als 10 µm auch eine n+ hochdotierte metamorphe Pufferschichtfolge NMP mit einer Dotierstoffkonzentration größer als 1•10¹⁷ N/cm³ und einer Schichtdicke oberhalb 0,2 µm und kleiner als 20 µm auf. Die n- Driftschicht NMID und die n+ hochdotierte metamorphe Pufferschichtfolge NMP sind stoffschlüssig miteinander verbunden.

Die metamorphe Pufferschichtfolge NMP weist eine Oberseite mit der ersten Gitterkonstante und eine Unterseite mit einer zweiten Gitterkonstante auf, wobei die erste Gitterkonstante größer als die zweite Gitterkonstante ist. Die Oberseite der metamorphen Pufferschichtfolge NMP ist in Richtung der Driftschicht NMID angeordnet.

An der Unterseite der metamorphen Pufferschichtfolge NMP ist eine zweite metallische Anschlusskontaktschicht M2 ausgebildet, so dass die zweite metallische Anschlusskontaktschicht M2 stoffschlüssig mit der metamorphen Pufferschichtfolge NMP verbunden ist.

Die vorgenannten Bereiche und Schichten sind in der genannten Reihenfolge angeordnet.

In einer alternativen nicht dargestellten Ausführungsform umfasst die hochsperrende III-V Halbleiterleistungsdiode weitere III-V Halbleiterschichten insbesondere an dem p/n Übergang und / oder zwischen einer sehr hochdotierten Halbleiterschicht oder Halbleiterbereich mit einer Dotierstoffkonzentration oberhalb von 1•10¹⁷ N/cm³ und einer niedrig dotierten Halbleiterschicht oder Halbleiterbereich mit einer Dotierstoffkonzentration unterhalb von 5•10¹⁷ N/cm³.

Die Abbildung der Figur 2 zeigt eine nicht beanspruchte Ausführungsform stapelförmige hochsperrende III-V-Halbleiterleistungsdiode LHD in einer n über p Struktur. Die Halbleiterleistungsdiode LHD weist eine gebietsweise ausgebildete erste metallische Anschlusskontaktschicht M1 und einen n+ hochdotierten Halbleiterkontaktbereich NPL mit einer Dotierstoffkonzentration größer als 1•10¹⁸ N/cm³ und mit einer ersten Gitterkonstante auf.

Der Halbleiterkontaktbereich NPL ist wannenförmig ausgebildet und ist vorzugsweise mittels eines Masken- und Implantationsprozesses hergestellt. Die erste metallische Anschlusskontaktschicht M1 und der n+ hochdotierte Halbleiterkontaktbereich NPL sind stoffschlüssig miteinander verbunden.

Zwischen dem n+ hochdotierte Halbleiterkontaktbereich NPL und einer p-Driftschicht PMID ist ein n- Zwischenbereich oder n- Zwischenschicht NMI in einer wannenförmigen Ausbildung angeordnet, so dass der n+ hochdotierte Halbleiterkontaktbereich NPL allseitig von der p- Driftschicht PMID beabstandet ist. Der n- dotierte Zwischenbereich ist als optionale Halbleiterschicht gestrichelt gezeichnet, d.h. in einer nicht dargestellten Ausführungsform ist der n- Zwischenbereich nicht ausgebildet.

Es versteht sich, dass ohne den n- Zwischenbereich NMI der n+ hochdotierte Halbleiterkontaktbereich NPL stoffschlüssig mit der p- Driftschicht PMID verbunden ist.

Der n- Zwischenbereich NMI weist eine Dotierung kleiner als der n+ hochdotierte Halbleiterkontaktbereich NPL und größer als die p- Driftschicht PMID auf und ist stoffschlüssig mit dem n+ hochdotierten Halbleiterkontaktbereich NPL und der p- Driftschicht PMID verbunden. Der n- Zwischenbereich NMI weist eine Dotierstoffkonzentration kleiner als 5•10¹⁵ N/cm³ und die erste Gitterkonstante und eine Dicke zwischen 1 µm und 30 µm auf.

Die III-V Halbleiterleistungsdiode LHD weist neben der p- Driftschicht PMID mit der ersten Gitterkonstante und mit einer Schichtdicke größer als 10 µm auch eine p+ hochdotierte metamorphe Pufferschichtfolge PMP mit einer Dotierstoffkonzentration größer als 1•10¹⁷ N/cm³ und einer Schichtdicke oberhalb 0,2 µm und kleiner als 20 µm auf. Die p- Driftschicht PMID und die p+ hochdotierte metamorphe Pufferschichtfolge PMP sind stoffschlüssig miteinander verbunden.

Die p+ metamorphe Pufferschichtfolge PMP weist an der Oberseite eine erste Gitterkonstante und an der Unterseite eine zweite Gitterkonstante auf, wobei die erste Gitterkonstante größer als die zweite Gitterkonstante ist. Die Oberseite der metamorphen Pufferschichtfolge PMP ist in Richtung der Driftschicht PMID angeordnet.

An der Unterseite der metamorphen Pufferschichtfolge PMP ist eine zweite metallische Anschlusskontaktschicht M2 ausgebildet, so dass die zweite metallische Anschlusskontaktschicht M2 stoffschlüssig mit der metamorphen Pufferschichtfolge PMP verbunden ist.

Die vorgenannten Bereiche und Schichten sind in der genannten Reihenfolge angeordnet. In einer alternativen nicht dargestellten Ausführungsform umfasst die hochsperrende III-V Halbleiterleistungsdiode weitere III-V Halbleiterschichten insbesondere an dem p/n Übergang und / oder zwischen einer sehr hochdotierten Halbleiterschicht oder Halbleiterbereich mit einer Dotierstoffkonzentration oberhalb von 1•10¹⁷ N/cm³ und einer sehr niedrig dotierten Halbleiterschicht oder Halbleiterbereich mit einer Dotierstoffkonzentration unterhalb von 5•10¹⁷ N/cm³.

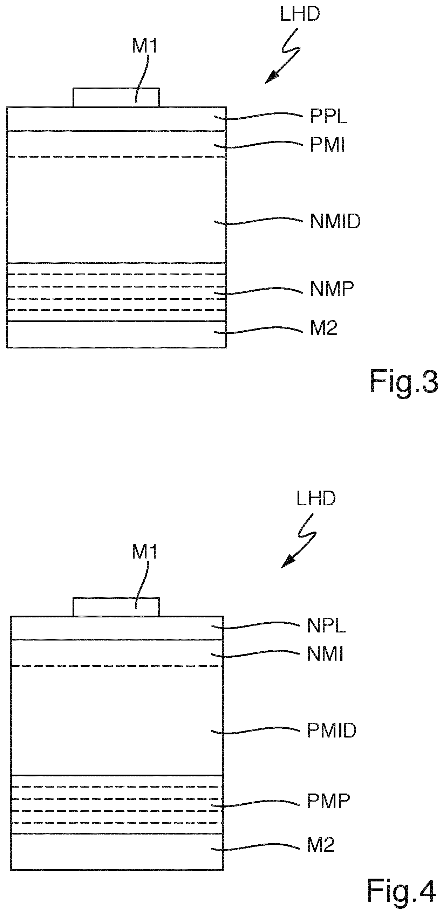

In der Figur 3 ist eine nicht beanspruchte Ausführungsform dritte Ausführungsform dargestellt. Im Folgenden werden nur die Unterschiede zu der Ausführungsform, dargestellt in Zusammenhang mit der Abbildung 1, erläutert.

Die Zwischenschicht PMI und die hochdotierte Halbleiterkontaktschicht PPL p+ sind jeweils plan ausgebildet. Derartige Schichtanordnungen werden mittels epitaktischer Prozesse insbesondere mittels einer MOVPE Anlage hergestellt. Die p dotierte Zwischenschicht ist gestrichelt gezeichnet, da die p dotierte Zwischenschicht optional ist, d.h. in einer nicht dargestellten Ausführungsform ist die p Zwischenschicht nicht ausgebildet.

In der Figur 4 ist eine nicht beanspruchte Ausführungsform vierte Ausführungsform dargestellt. Im Folgenden werden nur die Unterschiede zu der Ausführungsform, dargestellt in Zusammenhang mit der Abbildung 2, erläutert.

Die Zwischenschicht NMI und die hochdotierte Halbleiterkontaktschicht NPL n+ sind jeweils plan ausgebildet. Derartige Schichtanordnungen werden mittels epitaktischer Prozesse insbesondere mittels einer MOVPE Anlage hergestellt. Die n dotierte Zwischenschicht ist gestrichelt gezeichnet, da die n dotierte Zwischenschicht optional ist, d.h. in einer nicht dargestellten Ausführungsform ist die n Zwischenschicht nicht ausgebildet.

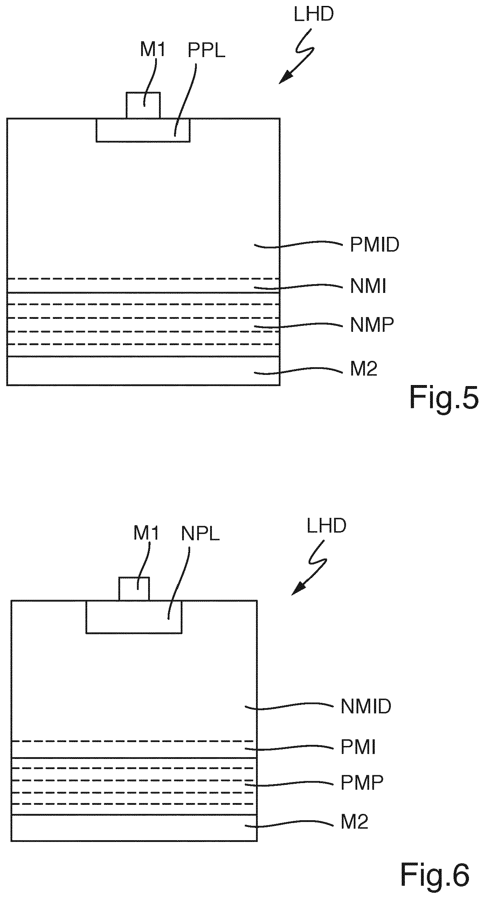

In der Figur 5 ist eine nicht beanspruchte Ausführungsform fünfte Ausführungsform dargestellt. Im Folgenden werden nur die Unterschiede zu der Ausführungsform, dargestellt in Zusammenhang mit der Abbildung 1, erläutert.

An den wannenförmig ausgebildeten hochdotierten p+ Halbleiterkontaktbereich PPL schließt sich stoffschlüssig die p- Driftschicht PMID an, wobei der p+ Halbleiterkontaktbereich PPL mittels einer Implantation in die p- Driftschicht PMID erzeugt ist. Hierdurch ist die p- Driftschicht an der Oberseite nicht mehr plan ausgebildet.

An die p- Driftschicht PMID schließt sich stoffschlüssig die n- dotierte Zwischenschicht NMI und die hochdotierte Pufferschicht NMP an, wobei die p-Driftschicht PMID an der Unterseite und die n-dotierte Zwischenschicht NMI an der Oberseite und an der Unterseite und die hochdotierte Pufferschicht NMP an der Oberseite und an der Unterseite plan ausgebildet sind.

Die n- dotierte Zwischenschicht NMI ist gestrichelt gezeichnet, da die n- dotierte Zwischenschicht NMI optional ist, d.h. in einer nicht dargestellten Ausführungsform ist die n- Zwischenschicht NMI nicht ausgebildet. Es versteht sich, dass ohne die n- Zwischenschicht NMI die Unterseite der p- Driftschicht PMID stoffschlüssig mit der Oberseite der n+ metamorphen Pufferschichtfolge NMP verbunden ist.

In der Figur 6 ist eine nicht beanspruchte Ausführungsform sechste Ausführungsform dargestellt. Im Folgenden werden nur die Unterschiede zu der Ausführungsform, dargestellt in Zusammenhang mit der Abbildung 2, erläutert.

An den wannenförmig ausgebildeten hochdotierten n+ Halbleiterkontaktbereich NPL schließt sich stoffschlüssig eine n- Driftschicht NMID an, wobei der n+ Halbleiterkontaktbereich NPL mittels einer Implantation in die n- Driftschicht NMID erzeugt ist. Hierdurch ist die n- Driftschicht NMID an der Oberseite nicht mehr plan ausgebildet.

An die n- Driftschicht NMID schließt sich stoffschlüssig eine p- dotierte Zwischenschicht PMI und die hochdotierte Pufferschicht an, wobei die n- Driftschicht NMID an der Unterseite und die p-dotierte Zwischenschicht PMI an der Oberseite und an der Unterseite und die hochdotierte Pufferschicht PMP an der Oberseite und an der Unterseite plan ausgebildet sind.

Die p dotierte Zwischenschicht PMI ist gestrichelt gezeichnet, da die p- dotierte Zwischenschicht PMI optional ist, d.h. in einer nicht dargestellten Ausführungsform ist die p- Zwischenschicht PMI nicht ausgebildet. Es versteht sich, dass ohne die p- Zwischenschicht PMI die Unterseite der n- Driftschicht NMID stoffschlüssig mit der Oberseite der p+ metamorphen Pufferschichtfolge PMP verbunden ist.

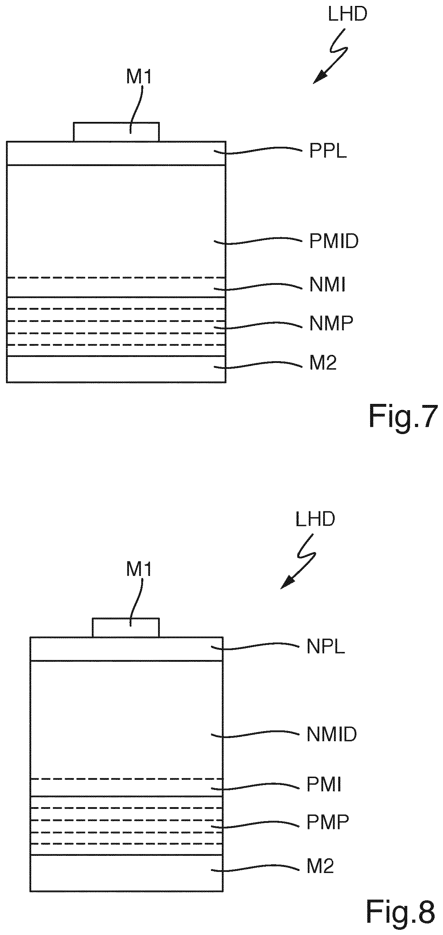

In der Figur 7 ist eine nicht beanspruchte Ausführungsform siebente Ausführungsform dargestellt. Im Folgenden werden nur die Unterschiede zu der Ausführungsform, dargestellt in Zusammenhang mit der Abbildung 5, erläutert.

An den schichtförmig ausgebildeten hochdotierten p+ Halbleiterkontaktbereich PPL schließt sich stoffschlüssig die p- Driftschicht PMID an, wobei der p+ Halbleiterkontaktbereich PPL mittels eines epitaktischen Prozessschrittes erzeugt ist. Hierdurch sind der p+ Halbleiterkontaktbereich PPL und die p- Driftschicht PMID jeweils planar ausgebildet.

In der Figur 8 ist eine nicht beanspruchte Ausführungsform achte Ausführungsform dargestellt. Im Folgenden werden nur die Unterschiede zu der Ausführungsform, dargestellt in Zusammenhang mit der Abbildung 6, erläutert.

An den schichtförmig ausgebildeten hochdotierten n+ Halbleiterkontaktbereich NPL schließt sich stoffschlüssig die n- Driftschicht NMID an, wobei der n+ Halbleiterkontaktbereich NPL mittels eines epitaktischen Prozessschrittes erzeugt ist. Hierdurch sind der n+ Halbleiterkontaktbereich NPL und die die n-Driftschicht NMID jeweils planar ausgebildet.

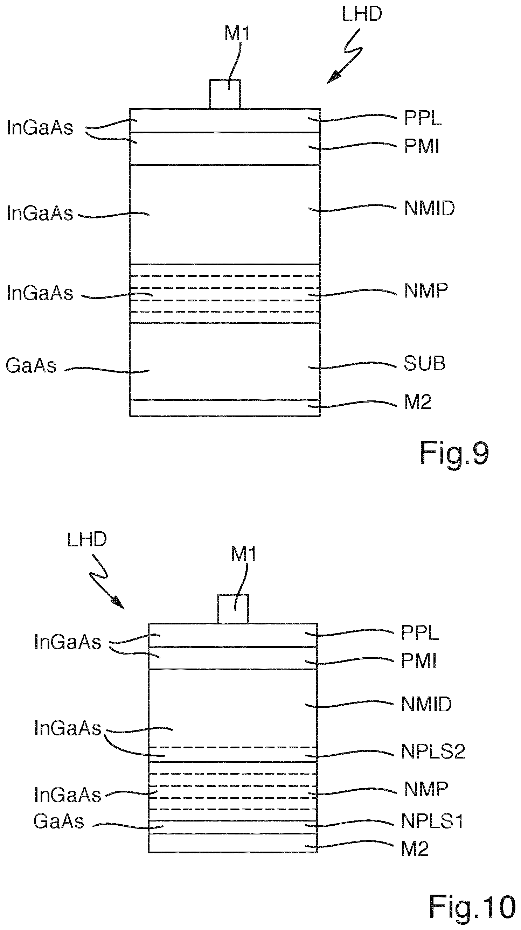

In der Figur 9 ist eine neunte erfindungsgemäße einer p über n Struktur dargestellt. Im Folgenden werden nur die Unterschiede zu den Ausführungsformen, dargestellt in Zusammenhang mit den Abbildungen der Figuren 1 und 3, erläutert.

Die an der Oberseite der stapelförmigen Halbleiterleistungsdiode LHD gebietsweise ausgebildete erste metallische Anschlusskontaktschicht M1 ist stoffschlüssig mit der Oberseite der aus einer InGaAs Verbindung bestehenden p+ hochdotierten Halbleiterkontaktschicht PPL verbunden. Die p+ hochdotierte Halbleiterkontaktschicht PPL ist mit der Unterseite stoffschlüssig mit der Oberseite der aus einer InGaAs Verbindung bestehenden p- Zwischenschicht PMI verbunden. Die p- Zwischenschicht PMI und die hochdotierte Halbleiterkontaktschicht p+ sind jeweils plan ausgebildet, wobei die beiden Schichtanordnungen vorzugsweise mittels epitaktischer Prozesse Insbesondere mittels einer MOVPE Anlage hergestellt sind.

Die Unterseite der p- Zwischenschicht PMI ist stoffschlüssig mit der Oberseite der aus einer InGaAs Verbindung bestehenden plan ausgebildeten n- Driftschicht NMID verbunden.

Die Unterseite der n- Driftschicht NMID ist stoffschlüssig mit der Oberseite der aus einer InGaAs Verbindung bestehenden plan ausgebildeten n+ hochdotierten metamorphen Pufferschichtfolge NMP verbunden.

Es versteht sich, dass die Oberseite der n+ hochdotierten metamorphen Pufferschichtfolge NMP die gleiche Gitterkonstante aufweist, wie die auf der Oberseite der n+ hochdotierten metamorphen Pufferschichtfolge NMP aufliegenden InGaAs Halbleiterschichten. Anders ausgedrückt, die aufliegenden InGaAs Halbleiterschichten sind zueinander gitterangepasst. Vorzugsweise weisen die InGaAs Schichten die Gitterkonstante von InP auf.

Die Unterseite der n+ hochdotierten metamorphen Pufferschichtfolge NMP ist stoffschlüssig mit der Oberseite eines n+ dotierten GaAs Substrats SUB verbunden. Das n+-dotierte GaAs Substrat ist vorzugsweise ungedünnt. Beispielsweise weist eine 4" GaAs-Scheibe eine Dicke von ca. 450 µm und eine 6" GaAs Scheibe eine Dicke von ca. 650 µm auf.

Die Unterseite des n+ dotierten GaAs Substrats SUB ist stoffschlüssig mit der ganzflächig ausgebildeten zweiten metallischen Anschlussschicht M2 verbunden. Die zweite metallische Anschlussschicht M2 besteht vorzugsweise aus einer Legierung aus Au und/oder Pd und/oder Ge.

In einer nicht dargestellten Ausführungsform sind zumindest teilweise die einzelnen aus der InGaAs-Verbindung bestehenden Halbleiterschichten nicht stoffschlüssig miteinander verbunden, indem weitere aus einer InGaAs-Verbindung bestehenden Schichten dazwischen ausgebildet sind. Beispielsweise lässt sich zwischen der n- Driftschicht NMID und der n+ hochdotierten metamorphen Pufferschichtfolge NMP eine weitere n dotierte Zwischenschicht anordnen, wobei die weitere n dotierte Zwischenschicht eine Dicke zwischen 13 µm und 15 µm aufweist. Des Weiteren ist die Dotierung der weiteren Zwischenschicht größer als die Dotierung der der n- Driftschicht NMID jedoch kleiner als die Dotierung der n+ hochdotierten metamorphen Pufferschichtfolge NMP.

Auch sei angemerkt, dass anstelle der p über n Struktur sich auch eine n über p Struktur entsprechend der Ausführungsformen dargestellt in Zusammenhang mit den Abbildungen der Figuren 4 oder 6 oder 8 ausbilden lässt.

In der Figur 10 ist eine erste erfindungsgemäße Ausführungsform dargestellt. Im Folgenden werden nur die Unterschiede zu der Ausführungsform, dargestellt in Zusammenhang mit der Abbildung 9, erläutert.

Zwischen der n+ hochdotierten metamorphen Pufferschichtfolge NMP und der zweiten metallischen Anschlusskontaktschicht M2 ist eine als Halbleiterkontaktschicht ausgebildete n+ erste hochdotierte Halbleiterschicht NPLS1 aus GaAs angeordnet. Die erste hochdotierte Halbleiterschicht NPLS1 weist eine Dotierstoffkonzentration größer als 1•10¹⁸ N/cm³ und eine Schichtdicke oberhalb von 0,1 µm und kleiner als 10 µm oder kleiner als 5 µm auf.

Zwischen der n- Driftschicht NMID und der n+ hochdotierten metamorphen Pufferschichtfolge NMP ist eine n+ zweite hochdotierte Halbleiterschicht NPLS2 aus einer InGaAs Verbindung angeordnet. Es versteht sich, dass die Gitterkonstante der n+ zweite hochdotierte Halbleiterschicht NPLS2 der Gitterkonstante der darüberliegenden n- Driftschicht NMID entspricht, d. h. die n+ zweite hochdotierte Halbleiterschicht NPLS2 und die n- Driftschicht NMID sind zueinander gitterangepasst.

Die n+ zweite hochdotierte Halbleiterschicht NPLS2 weist eine Dotierstoffkonzentration größer als 1•10¹⁸ N/cm³ und eine Schichtdicke oberhalb von 0,1 µm auf.

## Patentansprüche

1. Stapelförmige hochsperrende III-V-Halbleiterleistungsdiode (LHD), aufweisend
- eine zumindest gebietsweise ausgebildete erste metallische Anschlusskontaktschicht (M1),
- einen hochdotierten Halbleiterkontaktbereich (PPL, NPL) eines ersten Leitfähigkeitstyps mit einer Dotierstoffkonzentration größer als 1•10¹⁸ N/cm³ und mit einer ersten Gitterkonstante,
- eine dotierte Zwischenschicht (PMI, NMI) des ersten Leitfähigkeitstyps mit der ersten Gitterkonstante und mit einer Dicke zwischen 1 µm und 30 µm
- eine Driftschicht (NMID, PMID) eines zweiten Leitfähigkeitstyps mit der ersten Gitterkonstante und mit einer Schichtdicke größer als 10 µm, wobei die Dotierstoffkonzentration der Zwischenschicht größer als die Dotierstoffkonzentration der Driftschicht und kleiner als 5•10¹⁵ N/cm³ ist,
- eine aus InₓGa₁₋ₓAs mit 0≤x≤1 bestehende hochdotierte metamorphe Pufferschichtfolge (NMP, PMP) von dem zweiten Leitfähigkeitstyp mit einer Schichtdicke oberhalb 0,2 µm und kleiner als 20 µm, wobei die metamorphe Pufferschichtfolge (NMP, PMP) eine Oberseite mit der ersten Gitterkonstante und eine Unterseite mit einer zweiten Gitterkonstante aufweist und die Oberseite in Richtung der Driftschicht (NMID, PMID) angeordnet ist, wobei
an der Unterseite x<0,02 ist und x an der Oberseite größer als der Wert von x an der Unterseite ist, und die erste Gitterkonstante größer ist als die zweite Gitterkonstante, und
- eine unterhalb der Unterseite der metamorphen Pufferschichtfolge (NMP, PMP) ausgebildete zweite metallische Anschlusskontaktschicht (M2), wobei
- die vorgenannten Bereiche und Schichten in der genannten Reihenfolge angeordnet sind,
- zumindest der hochdotierte Halbleiterkontaktbereich (PPL, NPL) und die Driftschicht (NMID, PMID) eine III-V Verbindung umfassen oder aus einer III-V Verbindung bestehen,
- die Bandlücke an der Oberseite der metamorphen Pufferschichtenfolge kleiner als an der Unterseite der metamorphen Pufferschichtenfolge ist, und
- zwischen der metamorphen Pufferschichtfolge (NMP,PMP) und der zweiten metallischen Anschlusskontaktschicht (M2) eine Halbleiterkontaktschicht ausbildende erste hochdotierte Halbleiterschicht (NPLS1) mit der zweiten Gitterkonstante angeordnet ist und die erste hochdotierte Halbleiterschicht von demselben Leitfähigkeitstyp wie die metamorphen Pufferschichtfolge ist und eine Dotierstoffkonzentration größer als 1•10¹⁸ N/cm³ und eine Schichtdicke oberhalb von 0,1 µm aufweist, wobei die zweite metallische Anschlusskontaktschicht (M2) stoffschlüssig mit der Halbleiterkontaktschicht verbunden ist.

2. Stapelförmige hochsperrende III-V-Halbleiterleistungsdiode (LHD), aufweisend
- eine zumindest gebietsweise ausgebildete erste metallische Anschlusskontaktschicht,
- einen hochdotierten Halbleiterkontaktbereich (PPL, NPL) eines zweiten Leitfähigkeitstyps mit einer Dotierstoffkonzentration größer als 1•10¹⁸ N/cm³ und mit einer ersten Gitterkonstante,
- eine Driftschicht (NMID, PMID) des zweiten Leitfähigkeitstyps mit der ersten Gitterkonstante und mit einer Schichtdicke größer als 10 µm,
- eine dotierte Zwischenschicht eines ersten Leitfähigkeitstyps mit der ersten Gitterkonstante und mit einer Dicke zwischen 1 µm und 30 µm, wobei die Dotierstoffkonzentration der Zwischenschicht größer als die Dotierstoffkonzentration der Driftschicht und kleiner als 5•10¹⁵ N/cm³ ist,
- eine aus InₓGa₁₋ₓAs mit 0≤x≤1 bestehende hochdotierte metamorphe Pufferschichtfolge (NMP, PMP) von dem ersten Leitfähigkeitstyp mit einer Schichtdicke oberhalb 0,2 µm und kleiner als 20 µm, wobei die metamorphe Pufferschichtfolge (NMP, PMP) eine Oberseite mit der ersten Gitterkonstante und eine Unterseite mit einer zweiten Gitterkonstante aufweist und die Oberseite in Richtung der Driftschicht (NMID, PMID) angeordnet ist, wobei
an der Unterseite x<0,02 ist und x an der Oberseite größer als der Wert von x an der Unterseite ist, und wobei die erste Gitterkonstante größer ist als die zweite Gitterkonstante, und
- eine unterhalb der Unterseite der metamorphen Pufferschichtfolge (NMP, PMP) ausgebildete zweite metallische Anschlusskontaktschicht (M2), wobei
- die vorgenannten Bereiche und Schichten in der genannten Reihenfolge angeordnet sind, und
- zumindest der hochdotierte Halbleiterkontaktbereich (PPL, NPL) und die Driftschicht (NMID, PMID) jeweils eine III-V Verbindung umfassen oder aus einer III-V Verbindung bestehen, und
- die Bandlücke an der Oberseite der metamorphen Pufferschichtenfolge kleiner als an der Unterseite der metamorphen Pufferschichtenfolge ist, und
- zwischen der metamorphen Pufferschichtfolge (NMP,PMP) und der zweiten metallischen Anschlusskontaktschicht (M2) eine Halbleiterkontaktschicht ausbildende erste hochdotierte Halbleiterschicht (NPLS1) mit der zweiten Gitterkonstante angeordnet ist und die erste hochdotierte Halbleiterschicht von demselben Leitfähigkeitstyp wie die metamorphen Pufferschichtfolge ist und eine Dotierstoffkonzentration größer als 1•10¹⁸ N/cm³ und eine Schichtdicke oberhalb von 0,1 µm aufweist, wobei die zweite metallische Anschlusskontaktschicht (M2) stoffschlüssig mit der Halbleiterkontaktschicht verbunden ist.

3. Stapelförmige hochsperrende III-V-Halbleiterleistungsdiode (LHD) nach Anspruch 1 oder Anspruch 2, **dadurch gekennzeichnet, dass** die hochdotierte metamorphe Pufferschichtfolge (NMP, PMP) eine Dotierstoffkonzentration größer als 1•10¹⁶ N/cm³ aufweist.

4. Stapelförmige hochsperrende III-V-Halbleiterleistungsdiode (LHD) nach einem der vorangegangenen Ansprüche, **dadurch gekennzeichnet, dass** die erste metallische Anschlusskontaktschicht (M1) stoffschlüssig mit dem Halbleiterkontaktbereich (PPL, NPL) verbunden ist.

5. Stapelförmige hochsperrende III-V-Halbleiterleistungsdiode (LHD) nach Anspruch 1 oder Anspruch 2, **dadurch gekennzeichnet, dass** die hochdotierte metamorphe Pufferschichtfolge (NMP, PMP) eine Dotierstoffkonzentration größer als 5•10¹⁷ N/cm³ aufweist.

6. Stapelförmige hochsperrende III-V-Halbleiterleistungsdiode (LHD) nach Anspruch 1, **dadurch gekennzeichnet, dass** eine zweite hochdotierte Halbleiterschicht (NPLS2) mit der ersten Gitterkonstante zwischen der metamorphen Pufferschichtfolge (NMP,PMP) und der Driftschicht (NMID, PMID) ausgebildet ist und die zweite hochdotierte Halbleiterschicht (NPLS2) von dem zweiten Leitfähigkeitstyp ist und eine Dotierstoffkonzentration größer als 1•10¹⁸ N/cm³ und eine Schichtdicke oberhalb von 0,1 µm aufweist.

7. Stapelförmige hochsperrende III-V-Halbleiterleistungsdiode (LHD) nach Anspruch 2, **dadurch gekennzeichnet, dass** eine zweite hochdotierte Halbleiterschicht (NPLS2) mit der ersten Gitterkonstante zwischen der metamorphen Pufferschichtfolge (NMP,PMP) und der Driftschicht (NMID, PMID) ausgebildet ist und die zweite hochdotierte Halbleiterschicht (NPLS2) von dem ersten Leitfähigkeitstyp ist und eine Dotierstoffkonzentration größer als 1•10¹⁸ N/cm³ und eine Schichtdicke oberhalb von 0,1 µm aufweist.

8. Stapelförmige hochsperrende III-V-Halbleiterleistungsdiode (LHD) nach einem der vorangegangenen Ansprüche, **dadurch gekennzeichnet, dass** der Halbleiterkontaktbereich (PPL, NPL) und die zwischen dem Halbleiterkontaktbereich (PPL, NPL) und der Oberseite der metamorphen Pufferschichtfolge (NMP, PMP) angeordneten Halbleiterschichten jeweils aus einer InGaAs Verbindung oder aus InGaAs bestehen.

9. Stapelförmige hochsperrende III-V-Halbleiterleistungsdiode (LHD) nach einem der vorangegangenen Ansprüche, **dadurch gekennzeichnet, dass** der erste Leitfähigkeitstyp p und der zweite Leitfähigkeitstyp n ist oder der erste Leitfähigkeitstyp n und der zweite Leitfähigkeitstyp p ist.

10. Stapelförmige hochsperrende III-V-Halbleiterleistungsdiode (LHD) nach einem der vorangegangenen Ansprüche, **dadurch gekennzeichnet, dass** der Halbleiterkontaktbereich (PPL, NPL) als planare Schicht oder wannenförmig ausgebildet ist.

11. Stapelförmige hochsperrende III-V-Halbleiterleistungsdiode (LHD) nach Anspruch 1, **dadurch gekennzeichnet, dass** die erste hochdotierte Halbleiterschicht (NPLS1) aus GaAs besteht oder eine GaAs Verbindung umfasst und die Driftschicht (NMID, PMID) und der Halbleiterkontaktbereich (PPL, NPL) jeweils eine InGaAs Verbindung umfassen oder aus InGaAs bestehen.

12. Stapelförmige hochsperrende III-V-Halbleiterleistungsdiode (LHD) nach Anspruch 6 oder Anspruch 7, **dadurch gekennzeichnet, dass** die zweite hochdotierte Halbleiterschicht (NPLS2) und die Driftschicht (NMID, PMID) und der Halbleiterkontaktbereich (PPL, NPL) jeweils eine InGaAs Verbindung umfassen oder aus InGaAs bestehen.

13. Stapelförmige hochsperrende III-V-Halbleiterleistungsdiode (LHD) nach einem der vorstehenden Ansprüche, **dadurch gekennzeichnet, dass** der Halbleiterkontaktbereich (PPL, NPL) und die Halbleiterschichten monolithisch ausgebildet sind.

14. Stapelförmige hochsperrende III-V-Halbleiterleistungsdiode (LHD) nach einem der vorstehenden Ansprüche, **dadurch gekennzeichnet, dass** die Driftschicht (NMID, PMID) aus InₓGa₁₋ₓAs mit 0,1<x<0,6 besteht.

15. Stapelförmige hochsperrende III-V-Halbleiterleistungsdiode (LHD) nach einem der vorstehenden Ansprüche, **dadurch gekennzeichnet, dass** in der metamorphen Pufferschichtfolge (NMP, PMP) x von der Unterseite zu der Oberseite hin bis zu einem Grenzwert von x = 0,6 oder x = 0,4 zunimmt und wobei die Zunahme von x zwischen den einzelnen Schichten der Pufferschichtenfolge von der Unterseite zur Oberseite der Pufferschichtenfolge stufenförmig oder linear oder anderweitig ansteigend ausgebildet ist

## Claims

1. A stacked high-voltage-blocking III-V semiconductor power diode (LHD), comprising
- a first metallic terminal contact layer (M1) formed at least in regions,
- a highly doped semiconductor contact region (PPL, NPL) of a first conductivity type, having a dopant concentration greater than 1·10¹⁸ N/cm³ and a first lattice constant,
- a doped intermediate layer (PMI, NMI) of the first conductivity type, having the first lattice constant and a thickness between 1 µm and 30 µm,
- a drift layer (NMID, PMID) of a second conductivity type, having the first lattice constant and a layer thickness greater than 10 µm, wherein the dopant concentration of the intermediate layer is greater than the dopant concentration of the drift layer and is less than 5·10¹⁵ N/cm³,
- a highly doped metamorphic buffer layer sequence (NMP, PMP) of the second conductivity type, consisting of InₓGa₁₋ₓAs with 0≤x≤1 and having a layer thickness greater than 0.2 µm and less than 20 µm, wherein the metamorphic buffer layer sequence (NMP, PMP) has a top side with the first lattice constant and a bottom side with a second lattice constant, and the top side is arranged toward the drift layer (NMID, PMID), wherein x<0.02 at the bottom side and x at the top side is greater than the value of x at the bottom side, and
- the first lattice constant is greater than the second lattice constant, and
- a second metallic terminal contact layer (M2) formed below the bottom side of the metamorphic buffer layer sequence (NMP, PMP), wherein
- the aforementioned regions and layers are arranged in the stated order,
- at least the highly doped semiconductor contact region (PPL, NPL) and the drift layer (NMID, PMID) comprise a III-V compound or consist of a III-V compound,
- the bandgap at the top side of the metamorphic buffer layer sequence is smaller than the bandgap at the bottom side of the metamorphic buffer layer sequence, and
- a first highly doped semiconductor layer (NPLS1), which forms a semiconductor contact layer and has the second lattice constant, is arranged between the metamorphic buffer layer sequence (NMP, PMP) and the second metallic terminal contact layer (M2), the first highly doped semiconductor layer being of the same conductivity type as the metamorphic buffer layer sequence and having a dopant concentration greater than 1·10¹⁸ N/cm³ and a layer thickness greater than 0.1 µm, wherein the second metallic terminal contact layer (M2) is materially bonded to the semiconductor contact layer.

2. A stacked high-voltage-blocking III-V semiconductor power diode (LHD), comprising
- a first metallic terminal contact layer formed at least in regions,
- a highly doped semiconductor contact region (PPL, NPL) of a second conductivity type, having a dopant concentration greater than 1·10¹⁸ N/cm³ and a first lattice constant,
- a drift layer (NMID, PMID) of the second conductivity type, having the first lattice constant and a layer thickness greater than 10 µm,
- a doped intermediate layer of a first conductivity type, having the first lattice constant and a thickness between 1 µm and 30 µm, wherein the dopant concentration of the intermediate layer is greater than the dopant concentration of the drift layer and is less than 5·10¹⁵ N/cm³,
- a highly doped metamorphic buffer layer sequence (NMP, PMP) of the first conductivity type, consisting of InₓGa₁₋ₓAs with 0≤x≤1 and having a layer thickness greater than 0.2 µm and less than 20 µm, wherein the metamorphic buffer layer sequence (NMP, PMP) has a top side with the first lattice constant and a bottom side with a second lattice constant, and the top side is arranged toward the drift layer (NMID, PMID), wherein x<0.02 at the bottom side and x at the top side is greater than the value of x at the bottom side, wherein the first lattice constant is greater than the second lattice constant, and
- a second metallic terminal contact layer (M2) formed below the bottom side of the metamorphic buffer layer sequence (NMP, PMP), wherein
- the aforementioned regions and layers are arranged in the stated order, and
- at least the highly doped semiconductor contact region (PPL, NPL) and the drift layer (NMID, PMID) each comprise a III-V compound or consist of a III-V compound, and
- the bandgap at the top side of the metamorphic buffer layer sequence is smaller than the bandgap at the bottom side of the metamorphic buffer layer sequence,
and
- a first highly doped semiconductor layer (NPLS1), which forms a semiconductor contact layer and has the second lattice constant, is arranged between the metamorphic buffer layer sequence (NMP, PMP) and the second metallic terminal contact layer (M2), the first highly doped semiconductor layer being of the same conductivity type as the metamorphic buffer layer sequence and having a dopant concentration greater than 1·10¹⁸ N/cm³ and a layer thickness greater than 0.1 µm, wherein the second metallic terminal contact layer (M2) is materially bonded to the semiconductor contact layer.

3. The stacked high-voltage-blocking III-V semiconductor power diode (LHD) according to claim 1 or claim 2, **characterised in that** the highly doped metamorphic buffer layer sequence (NMP, PMP) has a dopant concentration greater than 1·10¹⁶ N/cm³.

4. The stacked high-voltage-blocking III-V semiconductor power diode (LHD) according to any one of the preceding claims, **characterised in that** the first metallic terminal contact layer (M1) is materially bonded to the semiconductor contact region (PPL, NPL).

5. The stacked high-voltage-blocking III-V semiconductor power diode (LHD) according to claim 1 or claim 2, **characterised in that** the highly doped metamorphic buffer layer sequence (NMP, PMP) has a dopant concentration greater than 5·10¹⁷ N/cm³.

6. The stacked high-voltage-blocking III-V semiconductor power diode (LHD) according to claim 1, **characterised in that** a second highly doped semiconductor layer (NPLS2) having the first lattice constant is formed between the metamorphic buffer layer sequence (NMP, PMP) and the drift layer (NMID, PMID), and the second highly doped semiconductor layer (NPLS2) is of the second conductivity type and has a dopant concentration greater than 1·10¹⁸ N/cm³ and a layer thickness greater than 0.1 µm.

7. The stacked high-voltage-blocking III-V semiconductor power diode (LHD) according to claim 2, **characterised in that** a second highly doped semiconductor layer (NPLS2) having the first lattice constant is formed between the metamorphic buffer layer sequence (NMP, PMP) and the drift layer (NMID, PMID), and the second highly doped semiconductor layer (NPLS2) is of the first conductivity type and has a dopant concentration greater than 1·10¹⁸ N/cm³ and a layer thickness greater than 0.1 µm.

8. The stacked high-voltage-blocking III-V semiconductor power diode (LHD) according to any one of the preceding claims, **characterised in that** the semiconductor contact region (PPL, NPL) and the semiconductor layers arranged between the semiconductor contact region (PPL, NPL) and the top side of the metamorphic buffer layer sequence (NMP, PMP) each consist of an InGaAs compound or of InGaAs.

9. The stacked high-voltage-blocking III-V semiconductor power diode (LHD) according to any one of the preceding claims, **characterised in that** the first conductivity type is p and the second conductivity type is n, or the first conductivity type is n and the second conductivity type is p.

10. The stacked high-voltage-blocking III-V semiconductor power diode (LHD) according to any one of the preceding claims, **characterised in that** the semiconductor contact region (PPL, NPL) is formed as a planar layer or in the shape of a well.

11. The stacked high-voltage-blocking III-V semiconductor power diode (LHD) according to claim 1, **characterised in that** the first highly doped semiconductor layer (NPLS1) consists of GaAs or comprises a GaAs compound, and the drift layer (NMID, PMID) and the semiconductor contact region (PPL, NPL) each comprise an InGaAs compound or consist of InGaAs.

12. The stacked high-voltage-blocking III-V semiconductor power diode (LHD) according to claim 6 or claim 7, **characterised in that** the second highly doped semiconductor layer (NPLS2), the drift layer (NMID, PMID) and the semiconductor contact region (PPL, NPL) each comprise an InGaAs compound or consist of InGaAs.

13. The stacked high-voltage-blocking III-V semiconductor power diode (LHD) according to any one of the preceding claims, **characterised in that** the semiconductor contact region (PPL, NPL) and the semiconductor layers are formed monolithically.

14. The stacked high-voltage-blocking III-V semiconductor power diode (LHD) according to any one of the preceding claims, **characterised in that** the drift layer (NMID, PMID) consists of InₓGa₁₋ₓAs with 0.1<x<0.6.

15. The stacked high-voltage-blocking III-V semiconductor power diode (LHD) according to any one of the preceding claims, **characterised in that**, in the metamorphic buffer layer sequence (NMP, PMP), x increases from the bottom side toward the top side up to a limit value of x=0.6 or x=0.4, and the increase in x between the individual layers of the buffer layer sequence from the bottom side to the top side of the buffer layer sequence is stepwise, linear or otherwise increasing.

## Revendications

1. Diode de puissance semi-conductrice III-V à structure empilée et à haute tenue en tension (LHD), comprenant
- une première couche de contact métallique de raccordement (M1), formée au moins par zones,
- une région de contact semi-conductrice fortement dopée (PPL, NPL) d'un premier type de conductivité, présentant une concentration en dopants supérieure à 1·10¹⁸ N/cm³ et une première constante de réseau,
- une couche intermédiaire dopée (PMI, NMI) du premier type de conductivité, présentant la première constante de réseau et une épaisseur comprise entre 1 µm et 30 µm,
- une couche de dérive (NMID, PMID) d'un deuxième type de conductivité, présentant la première constante de réseau et une épaisseur de couche supérieure à 10 µm, dans laquelle
la concentration en dopants de la couche intermédiaire est supérieure à la concentration en dopants de la couche de dérive et inférieure à 5·10¹⁵ N/cm³,
- une séquence de couches tampons métamorphiques fortement dopée (NMP, PMP) du deuxième type de conductivité, constituée d'InₓGa₁₋ₓAs avec 0≤x≤1 et présentant une épaisseur de couche supérieure à 0,2 µm et inférieure à 20 µm, la séquence de couches tampons métamorphiques (NMP, PMP) présentant une face supérieure ayant la première constante de réseau et une face inférieure ayant une deuxième constante de réseau, la face supérieure étant disposée du côté de la couche de dérive (NMID, PMID), dans laquelle
x<0,02 au niveau de la face inférieure et x au niveau de la face supérieure est supérieur à la valeur de x au niveau de la face inférieure, et
- la première constante de réseau est supérieure à la deuxième constante de réseau, et
- une deuxième couche de contact métallique de raccordement (M2), formée sous la face inférieure de la séquence de couches tampons métamorphiques (NMP, PMP), dans laquelle
- les régions et couches précitées sont disposées dans l'ordre indiqué,
- au moins la région de contact semi-conductrice fortement dopée (PPL, NPL) et la couche de dérive (NMID, PMID) comprennent un composé III-V ou sont constituées d'un composé III-V,
- la largeur de bande interdite au niveau de la face supérieure de la séquence de couches tampons métamorphiques est inférieure à celle au niveau de la face inférieure de la séquence de couches tampons métamorphiques, et
- une première couche semi-conductrice fortement dopée (NPLS1), formant une couche de contact semi-conductrice et présentant la deuxième constante de réseau, est disposée entre la séquence de couches tampons métamorphiques (NMP, PMP) et la deuxième couche de contact métallique de raccordement (M2), la première couche semi-conductrice fortement dopée étant du même type de conductivité que la séquence de couches tampons métamorphiques et présentant une concentration en dopants supérieure à 1·10¹⁸ N/cm³ et une épaisseur de couche supérieure à 0,1 µm, la deuxième couche de contact métallique de raccordement (M2) étant reliée par continuité de matière à la couche de contact semi-conductrice.

2. Diode de puissance semi-conductrice III-V à structure empilée et à haute tenue en tension (LHD), comprenant
- une première couche de contact métallique de raccordement, formée au moins par zones,
- une région de contact semi-conductrice fortement dopée (PPL, NPL) d'un deuxième type de conductivité, présentant une concentration en dopants supérieure à 1·10¹⁸ N/cm³ et une première constante de réseau,
- une couche de dérive (NMID, PMID) du deuxième type de conductivité, présentant la première constante de réseau et une épaisseur de couche supérieure à 10 µm,
- une couche intermédiaire dopée d'un premier type de conductivité, présentant la première constante de réseau et une épaisseur comprise entre 1 µm et 30 µm, la concentration en dopants de la couche intermédiaire étant supérieure à la concentration en dopants de la couche de dérive et inférieure à 5·10¹⁵ N/cm³,
- une séquence de couches tampons métamorphiques fortement dopée (NMP, PMP) du premier type de conductivité, constituée d'InₓGa₁₋ₓAs avec 0≤x≤1 et présentant une épaisseur de couche supérieure à 0,2 µm et inférieure à 20 µm, la séquence de couches tampons métamorphiques (NMP, PMP) présentant une face supérieure ayant la première constante de réseau et une face inférieure ayant une deuxième constante de réseau, la face supérieure étant disposée du côté de la couche de dérive (NMID, PMID), dans laquelle
x<0,02 au niveau de la face inférieure et x au niveau de la face supérieure est supérieur à la valeur de x au niveau de la face inférieure, la première constante de réseau étant supérieure à la deuxième constante de réseau, et
- une deuxième couche de contact métallique de raccordement (M2), formée sous la face inférieure de la séquence de couches tampons métamorphiques (NMP, PMP), dans laquelle
- les régions et couches précitées sont disposées dans l'ordre indiqué, et
- au moins la région de contact semi-conductrice fortement dopée (PPL, NPL) et la couche de dérive (NMID, PMID) comprennent chacune un composé III-V ou sont constituées d'un composé III-V, et
- la largeur de bande interdite au niveau de la face supérieure de la séquence de couches tampons métamorphiques est inférieure à celle au niveau de la face inférieure de la séquence de couches tampons métamorphiques,
et
- une première couche semi-conductrice fortement dopée (NPLS1), formant une couche de contact semi-conductrice et présentant la deuxième constante de réseau, est disposée entre la séquence de couches tampons métamorphiques (NMP, PMP) et la deuxième couche de contact métallique de raccordement (M2), la première couche semi-conductrice fortement dopée étant du même type de conductivité que la séquence de couches tampons métamorphiques et présentant une concentration en dopants supérieure à 1·10¹⁸ N/cm³ et une épaisseur de couche supérieure à 0,1 µm, la deuxième couche de contact métallique de raccordement (M2) étant reliée par continuité de matière à la couche de contact semi-conductrice.

3. Diode de puissance semi-conductrice III-V à structure empilée et à haute tenue en tension (LHD) selon la revendication 1 ou la revendication 2, **caractérisée en ce que** la séquence de couches tampons métamorphiques fortement dopée (NMP, PMP) présente une concentration en dopants supérieure à 1·10¹⁶ N/cm³.

4. Diode de puissance semi-conductrice III-V à structure empilée et à haute tenue en tension (LHD) selon l'une quelconque des revendications précédentes, **caractérisée en ce que** la première couche de contact métallique de raccordement (M1) est reliée par continuité de matière à la région de contact semi-conductrice (PPL, NPL).

5. Diode de puissance semi-conductrice III-V à structure empilée et à haute tenue en tension (LHD) selon la revendication 1 ou la revendication 2, **caractérisée en ce que** la séquence de couches tampons métamorphiques fortement dopée (NMP, PMP) présente une concentration en dopants supérieure à 5·10¹⁷ N/cm³.

6. Diode de puissance semi-conductrice III-V à structure empilée et à haute tenue en tension (LHD) selon la revendication 1, **caractérisée en ce qu'**une deuxième couche semi-conductrice fortement dopée (NPLS2), présentant la première constante de réseau, est formée entre la séquence de couches tampons métamorphiques (NMP, PMP) et la couche de dérive (NMID, PMID), et la deuxième couche semi-conductrice fortement dopée (NPLS2) est du deuxième type de conductivité et présente une concentration en dopants supérieure à 1·10¹⁸ N/cm³ et une épaisseur de couche supérieure à 0,1 µm.

7. Diode de puissance semi-conductrice III-V à structure empilée et à haute tenue en tension (LHD) selon la revendication 2, **caractérisée en ce qu'**une deuxième couche semi-conductrice fortement dopée (NPLS2), présentant la première constante de réseau, est formée entre la séquence de couches tampons métamorphiques (NMP, PMP) et la couche de dérive (NMID, PMID), et la deuxième couche semi-conductrice fortement dopée (NPLS2) est du premier type de conductivité et présente une concentration en dopants supérieure à 1·10¹⁸ N/cm³ et une épaisseur de couche supérieure à 0,1 µm.

8. Diode de puissance semi-conductrice III-V à structure empilée et à haute tenue en tension (LHD) selon l'une quelconque des revendications précédentes, **caractérisée en ce que** la région de contact semi-conductrice (PPL, NPL) et les couches semi-conductrices disposées entre la région de contact semi-conductrice (PPL, NPL) et la face supérieure de la séquence de couches tampons métamorphiques (NMP, PMP) sont chacune constituées d'un composé InGaAs ou d'InGaAs.

9. Diode de puissance semi-conductrice III-V à structure empilée et à haute tenue en tension (LHD) selon l'une quelconque des revendications précédentes, **caractérisée en ce que** le premier type de conductivité est p et le deuxième type de conductivité est n, ou le premier type de conductivité est n et le deuxième type de conductivité est p.

10. Diode de puissance semi-conductrice III-V à structure empilée et à haute tenue en tension (LHD) selon l'une quelconque des revendications précédentes, **caractérisée en ce que** la région de contact semi-conductrice (PPL, NPL) est réalisée sous la forme d'une couche plane ou en forme de puits.

11. Diode de puissance semi-conductrice III-V à structure empilée et à haute tenue en tension (LHD) selon la revendication 1, **caractérisée en ce que** la première couche semi-conductrice fortement dopée (NPLS1) est constituée de GaAs ou comprend un composé GaAs, et la couche de dérive (NMID, PMID) et la région de contact semi-conductrice (PPL, NPL) comprennent chacune un composé InGaAs ou sont constituées d'InGaAs.

12. Diode de puissance semi-conductrice III-V à structure empilée et à haute tenue en tension (LHD) selon la revendication 6 ou la revendication 7, **caractérisée en ce que** la deuxième couche semi-conductrice fortement dopée (NPLS2), la couche de dérive (NMID, PMID) et la région de contact semi-conductrice (PPL, NPL) comprennent chacune un composé InGaAs ou sont constituées d'InGaAs.

13. Diode de puissance semi-conductrice III-V à structure empilée et à haute tenue en tension (LHD) selon l'une quelconque des revendications précédentes, **caractérisée en ce que** la région de contact semi-conductrice (PPL, NPL) et les couches semi-conductrices sont réalisées de manière monolithique.

14. Diode de puissance semi-conductrice III-V à structure empilée et à haute tenue en tension (LHD) selon l'une quelconque des revendications précédentes, **caractérisée en ce que** la couche de dérive (NMID, PMID) est constituée d'InₓGa₁₋ₓAs avec 0,1<x<0,6.

15. Diode de puissance semi-conductrice III-V à structure empilée et à haute tenue en tension (LHD) selon l'une quelconque des revendications précédentes, **caractérisée en ce que**, dans la séquence de couches tampons métamorphiques (NMP, PMP), x augmente de la face inférieure vers la face supérieure jusqu'à une valeur limite x=0,6 ou x=0,4, et l'augmentation de x entre les différentes couches de la séquence de couches tampons, de la face inférieure à la face supérieure de la séquence de couches tampons, est réalisée par paliers, de manière linéaire ou de toute autre manière croissante.
